# EUROPÄISCHE PATENTSCHRIFT

(11) **EP 0 381 912 B1**
(45) Veröffentlichungstag und Bekanntmachung des Hinweises auf die Patenterteilung: **09.03.1994**
(21) Anmeldenummer: 89810239.7
(22) Anmeldetag: 31.03.1989
(51) Int. Cl.: H01J 37/30, C23C 14/30

(54) **Verfahren zum Zentrieren eines Elektronenstrahles**
Method to centre an electron beam
Procédé pour centrer un faisceau d'électrons

(30) Priorität: 09.02.1989 CH 455/89
(43) Veröffentlichungstag der Anmeldung: 16.08.1990
(73) Patentinhaber: BALZERS AKTIENGESELLSCHAFT, 9496 Balzers (LI)
(72) Erfinder: Friedel, Wolfgang, Dr., A-6800 Feldkirch (AT); Kaufmann, Helmut, Dr., FL-9495 Triesen (LI); Schmid, Roland, Dr., A-6811 Göfis (AT)
(74) Vertreter: Bruderer, Werner

(56) Entgegenhaltungen:
- EP-A- 0 131 699
- WO-A-83/00660
- DE-A- 2 823 876
- FR-A- 1 358 882
- FR-A- 2 155 589
- GB-A- 2 076 589

## Beschreibung

Die Erfindung betrifft ein Verfahren zum Zentrieren eines Elektronenstrahles bei Vakuum-Beschichtungsanlagen, wobei der Elektronenstrahl in einer Vakuumkammer von einer Kathode zu einer Rohmaterialquelle geführt und dort ein Brennfeld erzeugt wird, und mittels des Elektronenstrahles die Oberfläche der Rohmaterialquelle erwärmt und abgeschmolzen wird, und die Rohmaterialquelle entsprechend der Abschmelzung nachgeschoben wird, und eine Vorrichtung zur Durchführung dieses Verfahrens.

Es sind verschiedene Verfahren bekannt, um die Verdampfung von Beschichtungsmaterialien zu ermöglichen und in einer Vakuumkammer die Oberflächen von Substraten mit diesem Material zu beschichten. Es ist auch bekannt, in die Vakuumkammer zusätzliche Reaktivgase, wie Stickstoff oder Sauerstoff einzuführen, wodurch dann Oberflächenüberzüge aus entsprechenden Verbindungen entstehen. In der deutschen Patentschrift Nr. 28 23 876 ist ein derartiges Verfahren und eine Vorrichtung beschrieben. Dabei ist in einer Vakuumkammer konzentrisch um die Hauptachse ein Substratträger angeordnet, welcher die zu beschichtenden Teile trägt. Dabei kann es sich um Werkzeuge wie Fräser oder Bohrer oder um andere Objekte handeln, welche mit einer Oberflächenschicht versehen werden sollen, welche besondere mechanische, chemische oder optische Eigenschaften aufweisen soll. Im Zentrum der Anlage wird entlang der Längsachse der Vakuumkammer ein Elektronenstrahl geführt, welcher von einer Kathodenanordnung ausgeht und auf eine Rohmaterialquelle auftrifft. Durch die hohe Energie des Elektronenstrahles wird die Oberfläche der Rohmaterialquelle aufgeschmolzen und entsprechend dem beschriebenen Verfahren auf die Substrate aufgebracht. Der Elektronenstrahl wird mit Hilfe eines Magnetfeldes gebündelt und auf das Zentrum der Vakuumkammer ausgerichtet. Der Substratträger und die am Substratträger angeordneten zu beschichtenden Objekte stören dieses Magnetfeld, und diese Störungen haben zur Folge, dass der Elektronenstrahl abgelenkt und dadurch die Rohmaterialquelle nicht mehr in der gewünschten Weise beaufschlagt wird. Zusätzliche Schwierigkeiten ergeben sich, wenn der Substratträger oder die zu beschichtenden Objekte während des Beschichtungsvorganges rotiert oder in anderer Weise bewegt werden. In diesem Falle verändern sich die Beeinflussungen des Magnetfeldes laufend, und der Elektronenstrahl wird ungleichförmig ausgelenkt und gestört. Dies hat zur Folge, dass die Rohmaterialquelle ungleichförmig beaufschlagt und aufgeschmolzen wird. Der vom Elektronenstrahl erzeugte Brennfleck kann dabei im Extremfall auch ausserhalb der Rohmaterialquelle auf die umliegenden Halterungen auftreffen, was zu entsprechenden Erwärmungen und bei ungenügender Kühlung zu Beschädigungen dieser Anlagenbauelemente führen kann. Bei der bekannten Vorrichtung wird eine Rohmaterialquelle verwendet, welche in einem Tiegel angeordnet ist und nur eine bestimmte Menge von Beschichtungsmaterial enthalten kann.

Es ist auch bekannt, bei Anlagen mit hoher Verdampfungsrate als Rohmaterialquelle einen Barren oder eine Stange einzusetzen, welche laufend durch den Boden des Tiegels nachgeschoben werden kann. Diese Rohmaterialstange bildet die Anode und bei unbeeinflusstem Magnetfeld trifft der durch den Elektronenstrahl gebildete Brennfleck auf das Zentrum der Rohmaterialstange und bewirkt eine gleichmässige Aufschmelzung der Oberfläche. Wird der Elektronenstrahl aus dem Zentrum abgelenkt, so schmilzt die Stange einseitig ab, und es bildet sich ein einseitiger teigiger Kragen. Dieser einseitige Kragen ist auch weniger gut gekühlt, da er weiter von der gekühlten Halterung entfernt ist. Der teigige Teil des Kragens reagiert mit dem in der Vakuumkammer vorhandenen Reaktivgas, und die entstehende Verbindung hat zumeist einen höheren Schmelzpunkt als das reine Material. Dies führt zu Störungen des Beschichtungsprozesses, da dadurch die Verdampfungsrate verändert und der Abschmelzvorgang gestört wird. Dies kann zur Folge haben, dass der Beschichtungsvorgang unterbrochen werden muss und dadurch die zu beschichtenden Objekte eine minderwertige Qualität aufweisen oder gar ausgeschieden werden müssen.

In FR-A-1 358 882 wird ein Elektronenstrahl-Schmelzofen beschrieben, wobei eine Rohmaterialstange radial etwa rechtwinklig an den Elektronenstrahl herangeführt und abgetragen wird. Das von der Stange abgeschmolzene Material wird in einer Giessform aufgefangen. Dabei wird die Oberfläche des Materials in der Giessform vom Elektronenstrahl beaufschlagt. Mit Hilfe von Ablenkspulen wird der Elektronenstrahl auf einer kreisförmigen Bahn bewegt, und dadurch ein grösserer Bereich der Materialoberfläche in der Giessform beaufschlagt. Diese Anordnung ist für die Beschichtung von Oberflächen nicht geeignet. Sie ist nur bei genau definierten geometrischen Anordnungen funktionsfähig.

Der Erfindung liegt die Aufgabe zugrunde, ein Verfahren und eine Vorrichtung zu schaffen, welche das Zentrieren des Elektronenstrahles während des Beschichtungsvorganges ermöglicht, einen gleichmässigen Aufschmelzvorgang an der Oberfläche der Rohmaterialquelle erzeugt und welche in einfacher Weise bei den bekannten Anlagen und Verfahren angewendet werden können.

Diese Aufgabe wird verfahrensmässig durch die im kennzeichnenden Teil des Patentanspruches 1 definierten Merkmale und vorrichtungsmässig durch die im Patentanspruch 7 definierten Merkmale gelöst. Vorteilhafte Weiterbildungen der Erfindungen ergeben sich nach den Merkmalen der abhängigen Patentansprüche.

Bei dem erfindungsgemässen Verfahren kann die durch den Substrathalter und die Substrate bzw. deren Beeinflussung des Hauptmagnetfeldes erfolgte Auslenkung des Elektronenstrahles von der Idealachse korrigiert werden. Dies geschieht dadurch, dass quer zur Achse des Elektronenstrahles ein rotierendes Magnetfeld erzeugt wird, welches den Elektronenstrahl mit einem bestimmten Radius um eine Rotationsachse rotieren lässt. Das rotierende Magnetfeld wird mittels zweier um 90° versetzter Spulen erzeugt, welche mit um 90° phasenverschobenem Wechselstrom gespiesen werden. Die Achsen der beiden Magnetspulen liegen dabei etwa rechtwinklig zueinander und in einer Ebene, welche etwa rechtwinklig zur Achse des Elektronenstrahles verläuft. Dem rotierenden Magnetfeld überlagert können auf den gleichen Achsen, auf welchen die Magnetspulen für das rotierende Magnetfeld angeordnet sind, zusätzliche stationäre Magnetfelder erzeugt werden, welche der zusätzlichen Beeinflussung und Positionierung des Elektronenstrahles dienen. Diese zusätzlichen stationären Magnetfelder ermöglichen es, die Rotationsachse, um welche der Elektronenstrahl rotiert, in dem durch die beiden Achsen der Magnetspulen gebildeten Koordinatensystem zu verschieben, bis im optimalen Fall die Rotationsachse in Deckung mit der Achse der Rohmaterialquelle gebracht ist. Die Verdampfungsrate des Rohmateriales, welches durch den Elektronenstrahl geschmolzen wird, wird indirekt über den Verbrauch von Reaktivgas gemessen. Diese Reaktivgase dienen der Herstellung von Schichten aus Metallverbindungen, welche aus dem Rohmaterial und dem Reaktivgas entstehen. Dadurch lassen sich Nitrid-, Carbid-, Borid- oder Oxydschichten herstellen. Besonders geeignet ist das Verfahren und die Einrichtung für Carbid-Beschichtung, wobei in bekannter Weise Reaktivgase, wie z.B. Azethylen, Methan und andere Gase Verwendung finden. Wenn beim Betrieb der Anlage der Elektronenstrahl nicht auf das Zentrum der Rohmaterialquelle fällt, liegt auch die Rotationsachse, um welchen der Elektronenstrahl rotiert wird, ausserhalb der Achse der Rohmaterialquelle. Dadurch bestreicht der Elektronenstrahl nicht die ganze Oberfläche der Rohmaterialquelle, und diese wird ungleichförmig aufgeschmolzen bzw. abgetragen. In denjenigen Bereichen, wo der Elektronenstrahl im Extremfall überhaupt nicht auf die Rohmaterialquelle fällt, wird zu diesem Zeitpunkte gegenüber dem Durchschnittswert ein reduzierter Materialanteil verdampft. Fällt der Elektronenstrahl vollständig auf die Oberfläche der Rohmaterialquelle, so steigt die Verdampfungsrate merklich an. Bei erhöhter Verdampfungsrate reagiert mehr Rohmaterial mit dem Reaktivgas, und der Verbrauch an Reaktivgas steigt an. Mit Hilfe eines Sensorsystems wird dies festgestellt und der Anlage mehr Reaktivgas zugeführt. Dieser Mehrverbrauch an Reaktivgas wird in ein Messignal umgewandelt und einem Steuergerät zugeführt, in welchem die entsprechenden Signalwerte für Mehr- und Minderverbrauch mit den Wechselstromsignalen der Magnetspulen, welche das rotierende Magnetfeld erzeugen, verglichen werden. Aufgrund dieses zeitbezogenen Vergleiches kann festgestellt werden, in welcher Richtung die Rotationsachse des Elektronenstrahles im Achsenkreuz der Magnetspulen ausgelenkt ist. Entsprechend der festgestellten Auslenkung wird dem rotierenden Magnetfeld ein stationäres Magnetfeld überlagert und der rotierende Elektronenstrahl mit der Rotationsachse in Richtung der Achse der Rohmaterialquelle verschoben, bis die Rotationsachse mit der Achse der Rohmaterialquelle in Deckung gebracht ist. Dieses Verfahren ermöglicht eine automatische Steuerung derartiger Oberflächenbeschichtungsanlagen, bei welchen der Elektronenstrahl durch die eingebrachten Substrate oder die Substrathalter aus der Optimallage ausgelenkt wird. Da das Verfahren und die Vorrichtung selbstregelnd sind, bedarf es keiner Umstellungen, wenn andere Substrate oder andere Anordnungen im Bereiche des Substratträgers verwendet werden. Durch den um eine Achse rotierenden Elektronenstrahl ist es möglich, mit einem relativ kleinen Durchmesser des Elektronenstrahls die ganze Fläche der Rohmaterialquelle zu bestreichen und eine gleichmässige Aufschmelzung und Verdampfungsrate zu erreichen. Diese Anordnung ermöglicht auch, Rohmaterialquellen einzusetzen, welche abhängig von der Abschmelzungs- bzw. Verdampfungsrate kontinuierlich nachgeschoben werden können. Dies ermöglicht längere Chargenzeiten und weniger Unterbrüche zum Nachladen von Rohmaterial. Während eines Arbeitszykluses kann wesentlich mehr Material verdampft und auf die Substrate aufgebracht werden. Das erfindungsgemässe Verfahren und die entsprechende Vorrichtung ermöglichen somit einen wirtschaftlicheren Einsatz entsprechender Anlagen und erhöhen die Qualität der Beschichtungen, da die Verbindung von zu wenig aufgeheizten Randbereichen der Rohmaterialquelle mit den Reaktivgasen verhindert wird.

Im folgenden wird die Erfindung anhand von eine Ausführungsform darstellenden Zeichnungen näher erläutert. Es zeigen:
- Fig. 1: einen Längsschnitt durch eine erfindungsgemässe Vakuumbeschichtungsanlage in schematischer Darstellung,
- Fig. 2: einen Querschnitt durch die Vakuumkammer der Vakuumbeschichtungsanlage gemäss Fig. 1 in schematischer Darstellung und
- Fig. 3: die prinzipielle Anordnung der Bewegungen und Achsen an der Rohmaterialquelle.

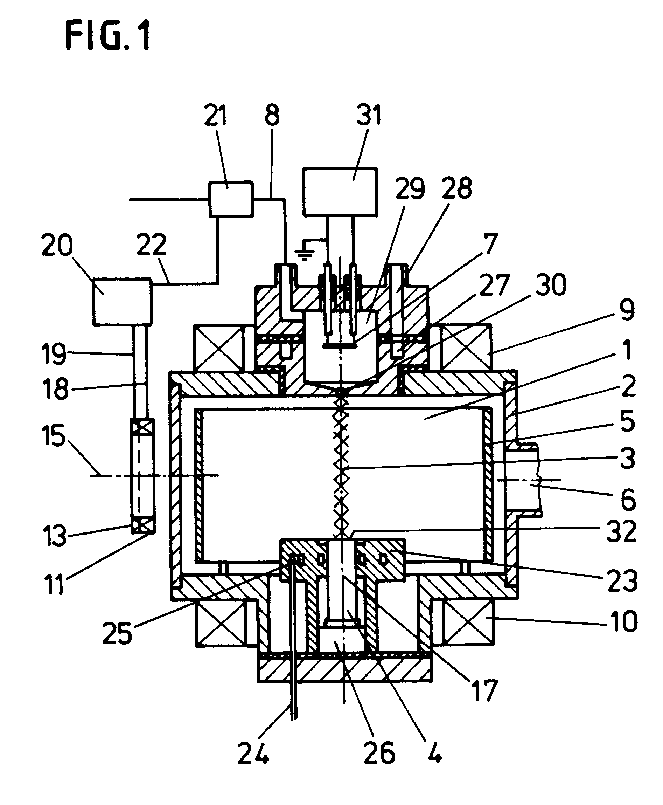

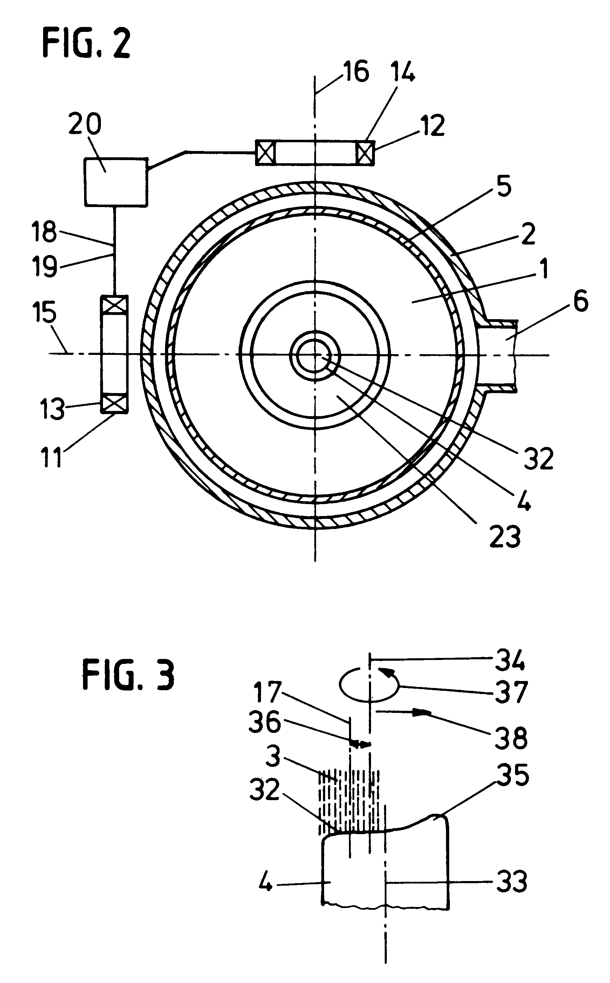

Die Vakuumbeschichtungsanlage gemäss Fig. 1 und 2 besteht aus einem Gehäuse 2, welches eine Vakuumkammer 1 umschliesst. In dieser Vakuumkammer 1 ist ein Substratträger 5 angeordnet, an welchem nicht dargestellte Werkstücke oder andere Objekte befestigt sind, deren Oberfläche beschichtet werden soll. Der Substratträger 5 und/oder die daran befestigten Objekte sind in nicht dargestellter Weise beweglich, um eine optimale Beschichtung deren Oberfläche zu gewährleisten. Am oberen Teil des Gehäuses 2 befindet sich eine Glühkathodenkammer 29, mit einer Kathode 7 und entsprechender Energiespeiseeinrichtungen 31. Die Glühkathodenkammer 29 ist über eine Oeffnung 30 mit der Vakuumkammer 1 verbunden. Am Boden der Vakuumkammer 1 befindet sich eine Rohmaterialquelle 4, welche in einem Kühlkragen 23 geführt und gehalten ist. Diese Rohmaterialquelle 4 ist stangenförmig ausgebildet und kann entsprechend dem abgeschmolzenen und verdampften Materialanteil nachgeschoben werden. Dazu ist unterhalb der Rohmaterialquelle 4 eine Vorschubeinrichtung 26 eingebaut. Der Kühlkragen 23 ist mit Kühlmittelkanälen 25 ausgerüstet, welche mit Kühlmittelleitungen 24 in Verbindung stehen. Am Gehäuse 2 ist ein Evakuierungsanschluss 6 angeordnet, über welchen in der Vakuumkammer 1 das gewünschte Vakuum erzeugt werden kann. Im Bereiche der Kathodenkammer 29 befindet sich ein Anschluss für eine Reaktivgasleitung 8, über welchen Reaktivgase wie z.B. Azethylen, Stickstoff oder Sauerstoff zugeführt werden, welche sich in bekannter Weise mit dem Verdampfungsmaterial verbinden. Wird beispielsweise eine Rohmaterialquelle 4 aus Titan benutzt und über die Reaktivgasleitung 8 Stickstoff zugeführt, so können Titanitrid-Beschichtungen oder bei Zuführung von Azethylen Titancarbid-Beschichtungen erstellt werden, welche besonders geeignet sind als Werkzeugüberzüge. Das Gehäuse im Bereiche der Kathodenkammer 29 ist ebenfalls mit Kühlkanälen 27 ausgestattet, welche über Kühlmittelleitungen 28 mit Kühlmittel versorgt werden. Zwischen Kathode 7 und der Oberfläche 32 der Rohmaterialquelle 4 wird beim Betrieb der Anlage ein Elektronenstrahl 3 erzeugt, welcher die Oberfläche 32 der Rohmaterialquelle 4 aufschmilzt und deren Material in die Vakuumkammer 1 verdampft. Zur Führung des Elektronenstrahles 3 sind am Gehäuse 2 Magnetspulen 9 und 10 angebracht, welche ein zur Achse 17 des Elektronenstrahles 3 paralleles Magnetfeld erzeugen. Mit Hilfe dieses Magnetfeldes wird der Elektronenstrahl 3 gebündelt und geführt. Abhängig von der Bestückung des Substratträgers 5 sowie der Form und Grösse der zu beschichtenden Substrate bzw. Objekte wird der Fluss des von den Spulen 9 und 10 erzeugten Magnetfeldes beeinflusst, und dadurch der Elektronenstrahl 3 von der theoretischen Achse 17 abgelenkt. Dies hat zur Folge, dass der vom Elektronenstrahl 3 erzeugte Brennfleck auf der Oberfläche 32 der Rohmaterialquelle 4 nicht mehr im Zentrum dieser Rohmaterialquelle 4 auftrifft und dadurch ein ungleichförmiges Abschmelzen der Rohmaterialquelle 4 erfolgt. Dies hat zur Folge, dass die teigigen Randbereiche, welche ungenügend erwärmt werden, mit dem Reaktivgas reagieren und dadurch Verbindungen bilden, welche erst bei einem höheren Schmelzpunkt aufschmelzen. Dies beeinträchtigt die Funktionsweise und Leistung der Beschichtungsanlage in erheblicher Weise. Nach einer gewissen Zeit muss das Nachschieben der Rohmaterialquelle 4 mit Hilfe der Vorschubeinrichtung 26 unterbrochen werden, da sich in demjenigen Bereich der Oberfläche 32 der Rohmaterialquelle 4, welche vom Elektronenstrahl 3 nicht mehr richtig erhitzt wird, ein überhöhter Kragen ausbildet.

Zur Verhinderung dieser Störungen sind bei der erfindungsgemässen Einrichtung zusätzliche erste Magnetspulen 11 und 12 und zweite Magnetspulen 13, 14 angeordnet. Diese Magnetspulen sind im dargestellten Beispiel ausserhalb des Gehäuses 2 angebracht, und zwar in einer Ebene, welche etwa rechtwinklig zur Achse 17 des Elektronenstrahles 3 steht. Die Achsen 15 und 16 der Spulen 11 und 12 liegen in der gleichen Ebene und stehen in einem Winkel von 90° zueinander. Mittels der beiden Spulen 11, 12 wird ein rotierendes Magnetfeld erzeugt, und zwar indem diese beiden Spulen 11, 12 über Leitungen 18 mit einer Wechselspannung gespiesen werden, welche je um 90° phasenverschoben ist. Mit Hilfe dieses rotierenden Magnetfeldes wird der Elektronenstrahl 3 in eine Kreis- bzw. Rotationsbewegung um eine Rotationsachse 34 versetzt. Als Folge dieser Rotationsbewegung des Elektronenstrahles 3 wird die Oberfläche 32 der Rohmaterialquelle 4 vom Brennfleck des Elektronenstrahles 3 nicht nur an einer Stelle getroffen, sondern als Folge der Rotationsbewegung eine grössere Fläche beaufschlagt. Ist nun der Abschmelzvorgang an der Oberfläche 32 der Rohmaterialquelle 4 ungleichförmig, so steigt die Abschmelzrate bzw. Verdampfungsrate an, wenn der Brennfleck des Elektronenstrahles 3 auf einen Bereich der Oberfläche 32 trifft, welcher überhöht ist, bzw. näher zur Kathode 7 liegt. Der überhöhte Bereich der Oberfläche 32 liegt auch weiter vom Kühlkragen 23 entfernt und wird deshalb weniger gekühlt. Infolge der höheren Verdampfungsrate wird mehr Reaktivgas in der Vakuumkammer 1 verbraucht. Der Verbrauch an Reaktivgas wird über den in Figur 1 dargestellten Durchflussmesser 21 gemessen, und entsprechende Abweichungen werden festgestellt. Dieser Durchflussmesser 21 ist Bestandteil einer nicht dargestellten Gasregelanlage für das Reaktivgas, welche über Sensoren und entsprechende Fördereinrichtungen für eine gleichbleibende Konzentration des Reaktivgases in der Vakuumkammer 1 sorgt. Die Messignale des Durchflussmessers 21 werden über eine Verbindungsleitung 22 einem Steuergerät 20 zugeführt, wobei dieses Steuergerät 20 auch die Wechselspannung der beiden Magnetspulen 11 und 12 steuert und regelt. Im Steuergerät 20 wird mit Hilfe bekannter elektronischer Schaltungen das Durchflussmessignal zeitabhängig mit den Wechselstromsignalen der Magnetspulen 11 und 12 verglichen und dadurch festgestellt, an welchen Stellen des durch die Achsen 15, 16 gebildeten Koordinatensystems höhere oder niedrigere Verdampfungsraten auftreten. Abhängig von diesen Feststellungen wird dem rotierenden Magnetfeld auf den Achsen 15 und/oder 16 ein stationäres Magnetfeld überlagert, welches den Elektronenstrahl 3 zusätzlich auslenkt. Dabei wird die Rotationsbewegung des Elektronenstrahles 3 um die Rotationsachse 34 beibehalten. Die Ueberlagerung des stationären Magnetfeldes erfolgt durch zusätzliche zweite Magnetspulen 13, 14, welche parallel zu den Magnetspulen 11, 12 angeordnet sind, oder diese zweiten Magnetspulen 13, 14 sind Bestandteile der ersten Magnetspulen 11, 12. Der Aufbau des überlagerten stationären Magnetfeldes erfolgt mit Gleichstromsignalen, welche ebenfalls vom Steuergerät 20 abgegeben und über Leitungen 19 zum Steuergerät geführt werden. Ziel des Zentrierverfahrens ist es, den Elektronenstrahl 3 so zu zentrieren, dass die Rotationsachse 34, um welchen der Strahl 3 rotiert, mit der Längsachse 33 der Rohmaterialquelle 4 zusammenfällt bzw. in Deckung gebracht wird. Da der Elektronenstrahl 3 um die Rotationsachse 34 rotiert, wird vom Brennfleck eine grössere Oberfläche bestrichen und die Aufschmelzrate kann erhöht werden, wobei gleichzeitig die ganze Oberfläche 32 der Rohmaterialquelle 4 gleichmässig erwärmt wird. Dadurch erfolgt eine optimale horizontale Erschmelzung der Oberfläche 32 und das Entstehen von überhöhten Kragen und das einseitige Abschmelzen wird verhindert. Dadurch wird die Störungsanfälligkeit entsprechender Vakuumbeschichtungsanlagen erheblich reduziert und es können längere Betriebszeiten erreicht werden. Die Qualität der Beschichtungen wird ebenfalls verbessert, da an der Oberfläche 32 der Rohmaterialquelle 4 immer gleiche Aufschmelz- und Verdampfungsbedingungen herrschen.

In Figur 3 ist der Ablauf der Vorgänge im Bereiche der Oberfläche 32 der Rohmaterialquelle 4 prinzipiell dargestellt. Der Elektronenstrahl 3 mit der Achse 17 rotiert in Richtung des Pfeiles 37 mit einem Radius 36 um die Rotationsachse 34. Dabei trifft der Brennfleck des Elektronenstrahles 3 nach 180° Rotationsbewegung auf den erhöhten Bereich 35 der Oberfläche 32 und es wird mehr Material der Rohmaterialquelle 4 verdampft. Ueber den Verbrauch von Reaktivgas und das Steuergerät 20 wird dies festgestellt und einer der Spulen 13, 14 oder beiden über die Leitungen 19 ein entsprechendes Gleichspannungssignal zugeführt, durch welches ein stationäres Magnetfeld aufgebaut wird, welches die Verschiebung des Elektronenstrahles 3 bzw. dessen Rotationsachse 34 in Richtung des Pfeiles 38 bewirkt. Bei Erreichen eines stationären Zustandes des Beschichtungsverfahrens wirkt das ganze Regelverfahren so, dass die Rotationsachse 34 mit der Achse 33 der Rohmaterialquelle 4 zusammenfällt und infolge der Rotationsbewegung die ganze Oberfläche 32 gleichmässig vom Elektronenstrahl 3 bestrichen wird. Im dargestellten Beispiel hat die Rohmaterialquelle 4 etwa einen Durchmesser von 40 mm, und die Verschiebung der Elektronenstrahlachse 17 gegenüber der Achse 33 der Rohmaterialquelle 4 beträgt max. ca. 20 mm. Zweckmässigerweise wird das rotierende Magnetfeld so aufgebaut, dass der Elektronenstrahl 3 etwa mit vier Umdrehungen pro Minute um die Rotationsachse 34 rotiert.

## Patentansprüche

1. Verfahren zum Zentrieren eines Elektronenstrahles bei Vakuum-Beschichtungsanlagen, wobei der Elektronenstrahl in einer Vakuumkammer von einer Kathode zu einer Rohmaterialquelle geführt und dort ein Brennfleck erzeugt wird und mittels des Elektronenstrahles die Oberfläche der Rohmaterialquelle erwärmt und abgeschmolzen wird und die Rohmaterialquelle entsprechend der Abschmelzung nachgeschoben wird, dadurch gekennzeichnet, dass etwa rechtwinklig zur Achse des Elektronenstrahles ein Magnetfeld erzeugt wird, dieses Magnetfeld in einer etwa rechtwinklig zur Achse des Elektronenstrahles liegenden Ebene um diesen rotiert wird, mit diesem Magnetfeld der Elektronenstrahl in eine Rotationsbewegung um eine Achse etwa parallel zur Achse der Rohmaterialquelle versetzt wird, Veränderungen der Verdampfungsrate des Rohmaterials gemessen werden und abhängig von der Verdampfungsrate die Achse der Rotationsbewegung durch Ueberlagerung von zusätzlichen Magnetfeldern in Deckung mit der Achse der Rohmaterialquelle gebracht wird.

2. Verfahren zum Zentrieren eines Elektronenstrahles nach Patentanspruch 1, dadurch gekennzeichnet, dass die Verdampfungsrate des Rohmaterials indirekt über Verbrauchsschwankungen eines in die Vakuumkammer eingeführten Reaktivgases gemessen wird.

3. Verfahren zum Zentrieren eines Elektronenstrahles nach einem der Patentansprüche 1 oder 2, dadurch gekennzeichnet, dass zur Verschiebung der Achse der Rotationsbewegung etwa rechtwinklig zur Achse zusätzliche stationäre Magnetfelder erzeugt werden und durch die Wirkung dieser stationären Magnetfelder der Elektronenstrahl verschoben wird.

4. Verfahren zum Zentrieren eines Elektronenstrahles nach einem der Patentansprüche 1 bis 3, dadurch gekennzeichnet, dass das rotierende Magnetfeld durch zwei sich kreuzende wechselnde Magnetfelder erzeugt wird und die Wechselwirkungen der beiden Magnetfelder um 90° gegeneinander phasenverschoben erzeugt werden.

5. Verfahren zum Zentrieren eines Elektronenstrahles nach einem der Patentansprüche 3 oder 4, dadurch gekennzeichnet, dass das rotierende Magnetfeld durch Wechselstrom und die stationären Magnetfelder durch Gleichstrom erzeugt werden.

6. Verfahren zum Zentrieren eines Elektronenstrahles nach einem der Patentansprüche 1 bis 5, dadurch gekennzeichnet, dass die aus der Verdampfungsrate abgeleiteten Messignale mit den Wechselspannungssignalen des elektrischen Speisestromes der die Rotationsbewegung erzeugenden Magnetfelder verglichen und aufgrund dieses Vergleiches die zur Korrektur notwendigen Gleichspannungssignale erzeugt und den Wechselspannungssignalen überlagert werden.

7. Vorrichtung zur Durchführung des Verfahrens gemäss Patentanspruch 1, dadurch gekennzeichnet, dass in einer Ebene im Bereiche des Elektronenstrahles (3) zwei erste Magnetspulen (11, 12) angeordnet sind, die Achsen (15, 16) dieser Magnetspulen (11, 12) etwa rechtwinklig zur Achse (17) des Elektronenstrahles (3) und etwa rechtwinklig zueinander verlaufen, diese beiden Magnetspulen (11, 12) je einen Wechselspannungsanschluss (18) aufweisen, parallel zu jeder der ersten Magnetspulen (11, 12) oder in diese integriert je eine zweite Magnetspule (13, 14) angeordnet ist und diese parallelen zweiten Magnetspulen (13, 14) je einen Gleichspannungsanschluss (19) aufweisen.

8. Vorrichtung nach Patentanspruch 7, dadurch gekennzeichnet, dass die ersten beiden Magnetspulen (11, 12) mit einem Steuergerät (20) verbunden sind, welches diese Magentspulen (11, 12) mit elektrischen Speisespannungen versorgt, welche je um 90° phasenverschoben sind.

9. Vorrichtung nach einem der Patentansprüche 7 oder 8, dadurch gekennzeichnet, dass die erste und die zweite Magnetspule (11, 13 bzw. 12, 14) durch eine einzige gemeinsame Magnetspule gebildet ist und die Anschlüsse dieser gemeinsamen Magnetspule gleichzeitig die Anschlüsse für die Gleich- und Wechselspannung sind.

10. Vorrichtung nach einem der Patentansprüche 7 bis 9, dadurch gekennzeichnet, dass die Vorrichtung einen Durchflussmesser (21) für das in die Vakuumkammer (1) eingeführte Reaktivgas aufweist und dieser Durchflussmesser (21) mit einem Steuergerät (20) für die Gleichspannungen der zweiten Magnetspulen (13, 14) verbunden ist und einen Steuersignalgeber bildet.

## Claims

1. Method for centring an electron beam in vacuum-coating equipment, whereby the electron beam is directed in a vacuum chamber from a cathode to a source of raw material and a focussed spot is produced at that point and the surface of the raw material source is heated by the electron beam and is melted away and the raw material source is fed in according to the ablation, characterised in that, a magnetic field is generated approximately at right-angles to the axis of the electron beam, this magnetic field lying in a plane that is approximately at right-angles to the axis of the electron beam and rotated about said axis, the electron beam being set by this magnetic field into rotary motion about an axis more or less parallel to the axis of the raw material source, and variations in the vaporisation rate of the raw material are measured and the axis of the rotary motion is brought into coincidence with the axis of the raw material source by superimposing additional magnetic fields in accordance with the vaporisation rate.

2. Method for centring an electron beam according to claim 1, characterised in that, the vaporisation rate of the raw material is measured indirectly by means of fluctuations in consumption of a reactive gas introduced into the vacuum chamber.

3. Method for centring an electron beam according to one of the claims 1 or 2, characterised in that, in order to displace the axis of rotary motion, additional stationary magnetic fields are generated at approximately right-angles to the axis and the electron beam is displaced by the action of these stationary magnetic fields.

4. Method for centring an electron beam according to one of the claims 1 to 3, characterised in that, the rotating magnetic field is generated by two crossing, alternating magnetic fields and the interactions of the two magnetic fields are such that they are phase-shifted by 90° to each other.

5. Method for centring an electron beam according to one of the claims 3 or 4, characterised in that, the rotating magnetic field is generated by alternating current and the stationary magnetic fields are generated by direct current.

6. Method for centring an electron beam according to one of the claims 1 to 5, characterised in that, the measuring signals derived from the vaporisation rate are compared to the alternating voltage signals of the electric supply current of the magnetic fields generating the rotary motion and, as a result of this comparison, the necessary direct voltage signals are generated for correction and are superimposed on the alternating voltage signals.

7. Device for implementing the method according to claim 1, characterised in that, two first magnet coils (11, 12) are arranged in a plane in the vicinity of the electron beam (3), the axes (15, 16) of these magnet coils (11, 12) running approximately at right-angles to the axis (17) of the electron beam (3) and approximately at right-angles to each other, these two magnet coils (11, 12) each having an alternating voltage connection (18), and a second magnet coil (13, 14) is arranged parallel to or is incorporated in each of the first magnet coils (11, 12) and each of these parallel, second magnet coils (13, 14) has a direct voltage connection (19).

8. Device according to claim 7, characterised in that, the first two magnet coils (11, 12) are connected to a control unit (20) which supplies these magnet coils (11, 12) with electric supply voltages, each of which are phase-shifted by 90°.

9. Device according to one of the claims 7 or 8, characterised in that, the first and the second magnet coils (11, 13 or 12, 14 respectively) are formed by a single, common magnet coil and the connections of this common magnet coil are simultaneously the connections for the direct voltage and the alternating voltage.

10. Device according to one of the claims 7 to 9, characterised in that, the device has a flowmeter (21) for the reactive gas introduced into the vacuum chamber (1) and this flowmeter (21) is connected to a control unit (20) for the direct voltages of the second magnet coils (13, 14) and forms a control signal generator.

## Revendications

1. Procédé de centrage d'un rayon d'électrons dans le cas d'installations d'enduction à vide, dans lequel le rayon d'électrons est guidé dans une chambre à vide depuis une cathode jusqu'à une source de matière brute et produit là un foyer et la surface de la source de matière brute chauffe au moyen du rayon d'électrons et est fondue et la source de matière brute est reculée conformément à la fusion, caractérisé en ce qu'un champ magnétique est produit approximativement perpendiculairement à l'axe du rayon d'électrons, en ce que ce champ magnétique est mis en rotation autour du rayon d'électrons dans un plan situé approximativement perpendiculairement à l'axe du rayon, en ce que le rayon d'électrons est déplacé par ce champ magnétique dans un mouvement de rotation autour d'un axe approximativement parallèle à l'axe de la source de matière brute, en ce que des modifications du taux d'évaporation de la matière brute sont mesurées et en ce qu'en fonction du taux d'évaporation, l'axe du mouvement de rotation est superposé à l'axe de la source de matière brute par l'intermédiaire d'une superposition de champs magnétiques supplémentaires.

2. Procédé de centrage d'un rayon d'électrons suivant la revendication 1, caractérisé en ce que le taux de vaporisation de la matière brute est mesuré de façon indirecte par des variations de consommation d'un gaz réactif introduit dans la chambre à vide.

3. Procédé de centrage d'un rayon d'électrons suivant l'une des revendications 1 et 2, caractérisé en ce que, pour le déplacement de l'axe du mouvement de rotation, des champs magnétiques stationnaires supplémentaires sont produits approximativement perpendiculairement à l'axe et le rayon d'électrons est déplacé par l'action de ces champs magnétiques stationnaires.

4. Procédé de centrage d'un rayon d'électrons suivant l'une quelconque des revendications 1 à 3, caractérisé en ce que le champ magnétique tournant est produit par deux champs magnétiques alternatifs qui se croisent et en ce que les actions alternatives des deux champs magnétiques sont produites de façon déphasée de 90° l'une par rapport à l'autre.

5. Procédé de centrage d'un rayon d'électrons suivant l'une des revendications 3 et 4, caractérisé en ce que le champ magnétique tournant est produit par un courant alternatif et les champs magnétiques stationnaires sont produits par un courant continu.

6. Procédé de centrage d'un rayon d'électrons suivant l'une quelconque des revendications 1 à 5, caractérisé en ce que les signaux de mesure dérivés du taux d'évaporation sont comparés aux signaux de tension alternative de la source d'alimentation électrique des champs magnétiques qui produisent le mouvement de rotation et en ce qu'en raison de cette comparaison, les signaux de tension continue nécessaires pour la correction sont produits et sont superposés aux signaux de tension alternative.

7. Dispositif pour la mise en oeuvre du procédé suivant la revendication 1, caractérisé en ce que dans un plan dans la zone du rayon d'électrons (3) sont agencées deux premières bobines magnétiques (11, 12), en ce que les axes (15, 16) de ces bobines magnétiques (11, 12) s'étendent approximativement perpendiculairement à l'axe (17) du rayon d'électrons (3) et approximativement perpendiculairement l'un à l'autre, en ce que ces deux bobines magnétiques (11, 12) présentent chacune un raccordement (18) à une tension alternative, en ce que parallèlement à chacune des premières bobines magnétiques (11, 12) ou de façon intégrée dans celles-ci est agencée chaque fois une seconde bobine magnétique (13, 14) et en ce que ces secondes bobines magnétiques (13, 14) en parallèle présentent chacune un raccordement (19) à une tension continue.

8. Dispositif suivant la revendication 7, caractérisé en ce que les deux premières bobines magnétiques (11, 12) sont reliées à un dispositif de commande (20) qui alimente ces bobines magnétiques (11, 12) avec des tensions d'alimentation électrique qui sont déphasées chacune de 90°.

9. Dispositif suivant l'une des revendications 7 et 8, caractérisé en ce que la première et la seconde bobine magnétique (11, 13 ou respectivement 12, 14) sont formées par une bobine magnétique unique commune et en ce que les raccordements de ces bobines magnétiques communes sont simultanément les raccordements pour la tension continue et la tension alternative.

10. Dispositif suivant l'une des revendications 7 à 9, caractérisé en ce que le dispositif présente un débitmètre (21) pour le gaz réactif introduit dans la chambre à vide (1) et en ce que ce débitmètre (21) est relié à un dispositif de commande (20) pour les tensions continues des secondes bobines magnétiques (13, 14) et forme un dispositif donnant des signaux de commande.
